# EUROPEAN PATENT APPLICATION

(11) **EP 1 113 089 A1**
(43) Date of publication of application: **04.07.2001**
(21) Application number: 00311759.5
(22) Date of filing: 29.12.2000
(51) Int. Cl.: C23C 16/40, C23C 16/448

(54) **MOCVD of lead zirconate titanate films**

(30) Priority: 30.12.1999 US 173818 P
(71) Applicant: Applied Materials, Inc., Santa Clara, California 95054 (US)
(72) Inventor: Wade, Christopher, Los Gatos CA 95032 (US); Sivaramakrishnan, Visweswaren, Santa Clara CA 95051 (US); Singh, Kaushal K., Santa Clara CA 95051 (US); Abooameri, Farid, Santa Clara CA 95051 (US); Mirkarimi, Laura, Sunol CA 94586 (US); Amano, Jun, Hillsborough CA 94010 (US); Zhao, Jun, Cupertino CA 95014 (US); Marston, Doug, Palo Alto CA 94306-3331 (US); Lim, Vicente, Newark CA 94560 (US)
(74) Representative: Bayliss, Geoffrey Cyril

(57) **Abstract**

Method and apparatus for metalorganic chemical vapor deposition of a lead zirconate titanate (PZT) film on a substrate is provided. The method for forming a PZT film comprises vaporizing and introducing vaporized lead bis (tetramethyl heptanedionate), zirconium bis (tetramethyl heptanedionate) bis (isopropoxy) and titanium bis (tetramethyl heptanedionate) bis (isopropoxy) into a chamber. The apparatus comprises a CVD chamber (20) having a gas distribution system (22) and a substrate support (24), one or more vaporizers (30a,c) fluidly connected to the gas distribution system of the CVD chamber, an oxygen gas source (31a,31b) fluidly connected to the gas distribution system of the CVD chamber; and one or more precursor sources (32) fluidly connected to the one or more vaporizers, the one or more precursor sources comprising Pb(thd)₂, Zr(OiPr)₂(thd)₂ and Ti(OiPr)₂(thd)₂.

## Description

The invention generally relates to chemical vapor deposition. More particularly, the invention relates to metalorganic chemical vapor deposition of a lead zirconate titanate film.

The increasing density of integrated circuits (ICs) is driving the need for materials with high dielectric constants to be used in electronic devices, such as capacitors for forming 256 MB and 1 GB DRAMs. Capacitors containing high-dielectric-constant materials, such as organometallic compounds, usually have much larger capacitance densities than standard SiO₂-Si₃N₄-SiO₂ stack capacitors making them the materials of choice in IC fabrication.

One organometallic compound of increasing interest as a material for use in ultra large scale integrated (ULSI) DRAMs is lead zirconate titanate (PZT) due to its high dielectric constant property. Deposition techniques used in the past to deposit PZT include RF magnetron sputtering, laser ablation, sol-gel processing, and chemical vapor deposition (CVD) of metal organic materials.

Lead-zirconium-titanium (PbZrₓTi₁₋ₓO₃) thin films and/or its related thin films can be used as ferroelectric thin films for semiconductor capacitors and other integrated circuit devices. PZT films are typically prepared from organometallic precursor sources, *e*.*g*., a combination of lead source, zirconium source and titanium source, and a metal-organic chemical vapor deposition (MOCVD) process is one of the preferred techniques for growing thin layers of compound semiconductors, such as the production of PZT thin films. In practice, MOCVD comprises vaporizing one or more liquid or solid organometallic precursors and decomposing the vapor by heat or plasma to deposit a thin film.

Organometallic precursors are selected to obtain desired properties and quality of the PZT thin film. The following are some general conditions that organometallic precursors should have. First, organometallic precursors should be easily volatilized at low preheat temperatures yet remain stable at the preheat temperatures. Second, the difference between the vaporization temperature and the decomposition temperature should be large enough to facilitate controlled deposition process. Third, the organometallic precursors should not decompose or be changed by the moisture contained in air. Finally, the organometallic precursors should be environmentally friendly or non-toxic.

Of the various organometallic precursors useful for preparing the PZT thin films, organometallic Ti precursors and organometallic Pb precursors are relatively well developed and may be volatized at relatively low temperatures. By contrast, organometallic Zr precursors are disadvantageous in that they are very hygroscopic or difficult to volatilize.

Conventionally, it is tetra (2,2',6,6'-tetramethyl-3,5-heptanedione) zirconium (hereinafter referred to as "Zr(thd)₄") that has been most commonly used as a zirconium precursor source for PZT thin films. Vaporized or volatilized Zr(thd)₄ exhibits good resistance to moisture and outstanding thermal stability without decomposition at temperatures below 300°C. However, the Zr(thd)₄ source for PZT thin film has a vaporization temperature that is much higher than the vaporization temperature of the Pb and Ti precursor sources. For example, Zr(thd)₄ is typically volatilized at a vaporizer temperature of about 280°C to 320°C, whereas a Pb precursor, such as Pb(thd)₄, is typically volatilized at vaporizer temperature of about 170°C to 190°C and a Ti precursor, such as Ti(OiPr)₄(thd)₄, is typically volatilized at vaporizer temperature of about 130°C to 250°C. Because the gap in vaporizing point between the Zr source and the other sources is large, it is difficult to control the temperature of a premixing chamber or preheat tube in which volatilized Pb, Ti and Zr precursors are mixed just before entering a reactor. For example, if the preheat temperature is controlled for the Pb or Ti precursor, the gas phase Zr(thd)₄ is highly apt to be solidified prior to entering the chamber. On the other hand, if the preheat temperature is raised for the Zr precursor, the Pb and Ti precursors are likely to be decomposed or changed before entering the reactor. Furthermore, preheating to a high temperature greater than about 250°C restrains selection of materials for bubbler or valve sealing. Consequently, Zr(thd)₄ presents many disadvantages for use as a precursor for deposition of PZT films.

In addition to problems imposed by the vaporization temperature differences, the conventional PZT precursors have not provided incorporation efficiencies into the deposited PZT film that meet commercial production requirements, resulting in excess waste of material. Furthermore, conventional PZT precursors have not provided satisfactory deposition rate and throughput for commercial production.

Therefore, there remains a need for a method and apparatus for forming metalorganic chemical vapor deposition of a lead zirconate titanate (PZT) film on a substrate which improves incorporation efficiencies for all three elements (Pb, Zr and Ti) and utilizes similar or common vaporization temperatures for the Pb, Zr and Ti precursors. It would be desirable for the method and apparatus for forming a PZT film to meet commercial production requirements, such as deposition rate, throughput and material incorporation efficiency.

The present invention provides a method and apparatus for metalorganic chemical vapor deposition of a lead zirconate titanate (PZT) film on a substrate.

One aspect of the invention provides a method for forming a PZT film on a substrate in a chemical vapor deposition chamber having one or more vaporizers fluidly connected thereto, comprising vaporizing lead bis (tetramethyl heptanedionate), zirconium bis (tetramethyl heptanedionate) bis (isopropoxy) and titanium bis (tetramethyl heptanedionate) bis (isopropoxy) and introducing vaporized lead bis (tetramethyl heptanedionate), zirconium bis (tetramethyl heptanedionate) bis (isopropoxy) and titanium bis (tetramethyl heptanedionate) bis (isopropoxy) into a chamber.

Another aspect of the invention provides an apparatus for forming a PZT film on a substrate comprising a CVD chamber having a gas distribution system and a substrate support, one or more vaporizers fluidly connected to the gas distribution system of the CVD chamber, an oxygen gas source fluidly connected to the gas distribution system of the CVD chamber; and one or more precursor sources fluidly connected to the one or more vaporizers, the one or more precursor sources comprising Pb(thd)₂, Zr(OiPr)₂(thd)₂ and Ti(OiPr)₂(thd)₂.

Another aspect of the invention provides a vaporizable precursor for forming a PZT film on a substrate in a chamber comprising Pb(thd)₂, Zr(OiPr)₂(thd)₂, Ti(OiPr)₂(thd)₂ and a solvent.

So that the manner in which the above recited features, advantages and objects of the present invention are attained can be understood in detail, a more particular description of the invention, briefly summarized above, may be had by reference to the embodiments thereof which are illustrated in the appended drawings.

It is to be noted, however, that the appended drawings illustrate only typical embodiments of this invention and are therefore not to be considered limiting of its scope, for the invention may admit to other equally effective embodiments.

Figure 1 is schematic diagram illustrating a chemical vapor deposition (CVD) system 10.

Figure 2 is a cross sectional view of a vaporizer 100.

Figure 3 is a graphical representation illustrating the effects of substrate temperature on Zr/Ti ratio in a PZT film.

Figure 4 is schematic diagram illustrating a CVD system 400 incorporating three vaporizers.

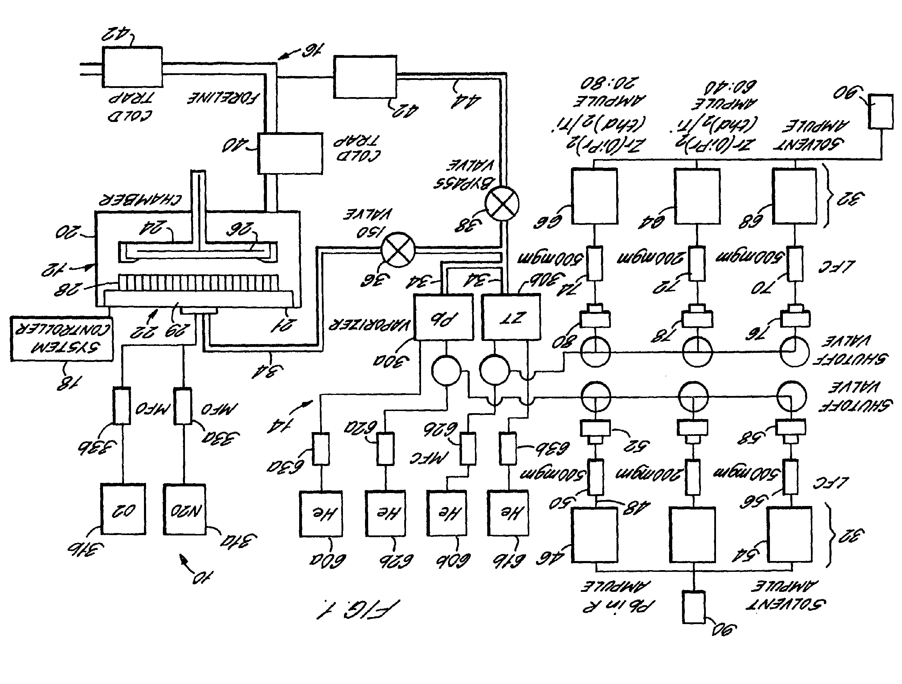

Figure 1 is schematic diagram illustrating a chemical vapor deposition (CVD) system 10. An example of a CVD system is the Giga-Cap Centura® System, available form Applied Materials, Inc., Santa Clara, California. The CVD system 10 generally includes a CVD chamber 12, a gas delivery system 14, an exhaust system 16 and a system controller 18 which controls the operation of all components of the system. The CVD chamber 12 generally includes a chamber body 20, a chamber lid 21 having a gas distribution system 22 and a substrate support member 24. The substrate support member 24 comprises ceramic or aluminum nitride (AlN) and includes a heater 26, such as a resistive heating coil disposed inside the substrate support member, and may also substrate chucking mechanisms for securely holding a substrate, such as a vacuum chuck or an electrostatic chuck. The gas distribution system 22 includes a gas distributor 28, such as a showerhead type gas distributor, for providing a uniform process gas distribution over a substrate disposed on the substrate support member 24. A temperature control system 29, such as a resistive heating coil and/or thermal fluid channels, is disposed in the lid and thermally connected to the gas distribution system 22. The temperature control system maintains the temperature of the gas distribution system 22 within a desired range throughout processing. The gas distribution system 22 is fluidly connected to the gas delivery system 14. The gas distribution system 22 may also be fluidly connected to additional gas sources through additional MFCs. For example, as shown in Figure 1, the gas distribution system 22 is connected to an N₂O source 31a and an O₂ source 31b through MFCs 33a, 33b, which control the flow rate of the respective gases into the chamber. Alternatively, the O₂ source 31b can be substituted by an ozone (O₃) source 31b. The gases introduced as the oxygen flow into the chamber may include N₂O, O₂, O₃, or combinations of N₂O with either O₂ or O₃.

The gas delivery system 14 includes one or more vaporizers 30a, 30b, one or more liquid precursor sources 32 connected to the one or more vaporizers 30a, 30b, and one or more fluid connection lines 34 for transporting the gaseous output of the vaporizers to the gas distribution system 22 of the CVD chamber 12. One or more valves, such as an isovalve 36, is disposed on the one or more fluid connection lines 34 to control the amount of gas flowing to the gas distribution system 22 of the CVD chamber 12. The output of the one or more vaporizers 30a, 30b are also connected to a bypass valve 38 which is disposed on a bypass line 44 connected to the exhaust system 16.

The exhaust system 16 includes one or more vacuum pumps 40, such as a turbomolecular pump, connected to exhaust gases from and maintain vacuum levels in the CVD chamber 12. The one or more vacuum pumps 40 are connected to a gas outlet or exhaust through a valve such as a gate valve. One or more cold traps 42 are disposed on exhaust lines to remove or condense particular gases exhausted from the chamber. One or more cold traps 42 may also be disposed on the bypass line 44 between the bypass valve 38 and the connection to the exhaust system.

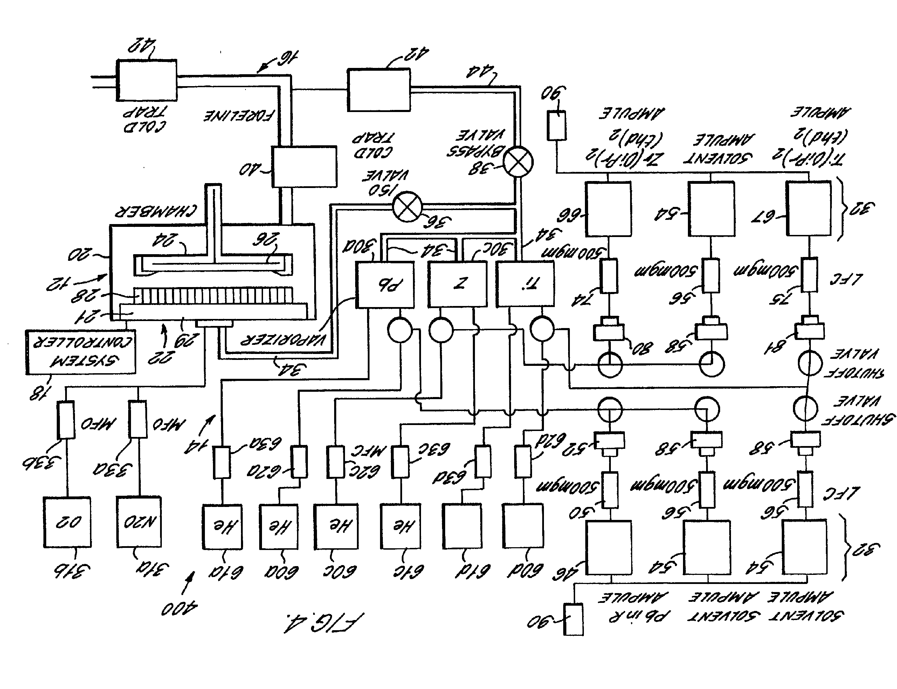

In one embodiment of the invention, as shown in Figure 1, two vaporizers 30a, 30b are utilized for vaporizing the precursors for PZT. A first vaporizer vaporizes the Pb precursor while a second vaporizer vaporizes both the Zr precursor and the Ti precursor. The Pb precursor comprises lead bis (tetramethyl heptanedionate), *i*.*e*., Pb(thd)₂. The Zr precursor comprises zirconium bis (tetramethyl heptanedionate) bis (isopropoxy), *i*.*e*., Zr(OiPr)₂(thd)₂. The Ti precursor comprises titanium bis (tetramethyl heptanedionate) bis (isopropoxy), *i*.*e*., Ti(OiPr)₂(thd)₂. Concentration of the precursors may be from about 0.01M (molar) to about 10M, preferably from about 0.1M to about 0.5M. Although two vaporizers are shown for the embodiment in Figure 1, the invention contemplates utilizing a single vaporizer for vaporizing all three precursors. Alternatively, as shown in Figure 4, one vaporizer is provided for each precursor (e.g., one vaporizer for Pb precursor, one vaporizer for Zr precursor and one vaporizer for Ti precursor).

The Pb precursor is provided in an ampoule 46, which is connected to the vaporizer 30a through a liquid delivery line 48. A liquid flow controller (LFC) 50 is disposed on the liquid delivery line 48 to control the flow rate of precursor liquid to the vaporizer. A shutoff valve 52 is disposed on the liquid delivery line to prevent backflow or to terminate precursor flow when necessary. In addition to the Pb ampoule, a first solvent ampoule 54 is also fluidly connected to the vaporizer, in similar fashion as the Pb ampoule, with an LFC 56 and a shutoff valve 58. One or more push gas sources 90 (one shown) are connected to the Pb ampoule and the first solvent ampoule to provide a push gas pressure (e.g., from about 20 psi to about 200 psi) to the precursor or solvent liquids in the ampoules.

A first carrier gas source (i.e., carrier gas A) 60a, 60b, such as argon (Ar) and/or helium (He), is connected to the vaporizer 30a, 30b through a gas delivery line, and a mass flow controller (MFC) 62a, 62b, is disposed on the gas delivery line to control the flow rate of the carrier gas. A second carrier gas source (i.e., carrier gas B) 61a, 61b, may also be connected through MFCs 63a, 63b, to the vaporizers 30a and 30b, respectively. Carrier gas sources may provide gases such as Argon, Helium, Xenon, Neon, Krypton, or Nitrogen, as carrier gas A and/or carrier gas B.. The liquid and gas delivery lines are preferably made of a material having a low coefficient of friction, such as PTFE, to allow for high flow velocities. The invention contemplates utilizing other devices, such as bubblers, degassers, shut-off valves, and other devices, which are commonly known in the industry and used with typical liquid and gas delivery system.

The Zr precursor ampoule 64, the Ti precursor ampoule 66 and a second solvent ampoule 68 are fluidly connected to the second vaporizer 30b through a liquid delivery line. Each of the ampoules is connected to the liquid delivery line through an LFC 70, 72, 74, and a shutoff valve 76, 78, 80, which control the flow rate from the ampoule. One or more push gas sources 90 (one shown) are connected to the Zr ampoule, the Ti ampoule and the first solvent ampoule to provide a push gas pressure (e.g., from about 20 psi to about 200 psi) to the precursor or solvent liquids in the ampoules.

The gas outlets of the vaporizers 30a, 30b are connected, and the vaporized precursors from the first and second vaporizers are combined in the outlet connection, which then flow either through the isovalve 36 to the CVD chamber 12 or through the bypass valve 38 to the exhaust system 16. The vaporized precursors flowing to the chamber are introduced through the gas distributor 28 into the processing region and deposit onto a substrate on the substrate support member 24. The substrate support member 24 may be spaced from the gas distributor 28 at a distance between about 100 mils to about 800 mils, preferably between about 500 mils and 600 mils. The chamber pressure may be maitained at between about 0.1 torr and about 100 torr, preferably between about 1 torr and about 10 torr.

As an example, the Pb precursor comprises 0.25M Pb(thd)₂ in R flow, while the Zr/Ti precursor comprises 0.060M Zr(OiPr)₂(thd)₂ + 0.040M Ti(OiPr)₂(thd)₂ in R flow and 0.020M Zr(OiPr)₂(thd)₂ + 0.080M Ti(OiPr)₂(thd)₂ in R flow, wherein R represent a solvent comprising 8:2:1 THF:IPA:PMDETA, wherein tetrahydrofuran is THF, isopropyl alcohol is IPA, and pentamethyldiethylenetriamine is PMDETA.

The inventors contemplate a variety of solvents, including organic straight-chain hydrocarbons (e.g., octane, heptane, decane, hexanes, etc.), aromatic hydrocarbons (e.g., benzene, toluene, cyclenes, etc.), ethers (e.g., diethyl ether, dimethyl ether, etc.), cyclic ethers (e.g., tetrahydrofuran, etc.), keytones (e.g.,acetone, formaldehyde, etc.) or alcohols (e.g., isopropanol, ethanol, methanol, etc.). The solvent may include solvent additives or stabilizers/complexing agent such as EDTA, ethylenediamine, PMDETA, etc. In one embodiment, the solvent comprises octane or tetrahydrofuran, with optionally added isopropyl alcohol and stabilizers such as PMDETA.

The inventors also recognize that if the vaporizer is substantially maintained at an ideal isothermal system temperature, deposition layer uniformity can be enhanced and that maintenance of the gas delivery system can be reduced. The vaporizer 100 incorporates several active and passive thermal control systems including thermal control features which serve to protect a main seal by cooling it below the ideal isothermal system temperature. Cooling is achieved without inducing significant temperature fluctuations and gradients in the vaporizer components exposed to the chemical fluids (liquid and/or gas) flowing through the vaporizer, and without excessive cooling and heating power losses.

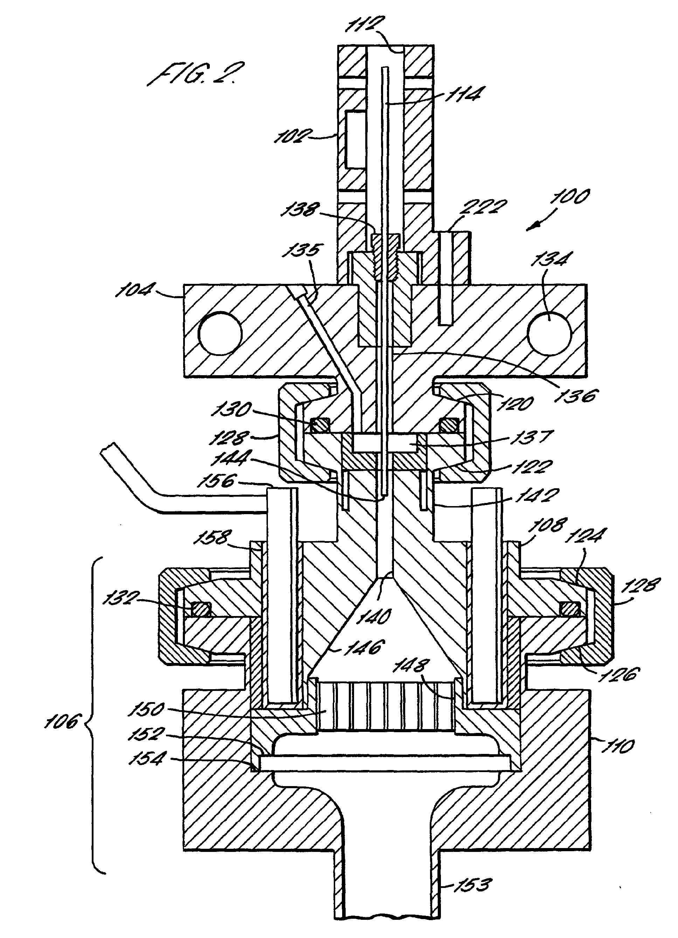

Figure 2 is a cross sectional view of a vaporizer 100. The vaporizer 100, which represents the first and second vaporizers 30a, 30b, generally includes an input manifold 102, a cooling head 104, and a main body 106 comprising a top block 108 and a bottom block 110. The input manifold 102 is coupled at the upper end of the vaporizer 100 and provides an inlet 112 wherein an injection member 114, such as a capillary tube, is coaxially disposed. The injection member 114 is connected to the one or more liquid precursor ampoules (such as ampoules 46, 54, 64, 66, 68, as shown in Figure 1) and the carrier gas A source (such as 60a, 60b, as shown in Figure 1).

The cooling head 104 and the top block 108 are joined at abutting flanges 120 and 122 formed on the head 104 and top block 108, respectively. Similarly, the top block 108 and the bottom block 110 are joined at flanges 124 and 126 defined on the top block 108 and bottom block 110, respectively. The flanges 120, 122, 124, and 126 are adapted to receive clamps 128, such as KF clamps, to hold the various vaporizer components together during operation. O-ring seals 130 and 132 disposed in flanges 120 and 124, respectively, provide hermetic seals at the interfaces of the blocks 108, 110 and cooling head 104. O-rings 130, 132 may be any of many high temperature metal-to-metal seals, such as the aluminum Delta seal from Helicoflex.

One or more cooling channels 134 are disposed in the head 104 to actively cool the O-ring seal 130 and the incoming liquid precursors. A heat exchange fluid (*e*.*g*., water, ethylene glycol, silicone oil, etc.) circulates through the channel 134 to remove heat at the O-ring seal 130. Optionally, another cooling channel (not shown) may be disposed in the main body 106 adjacent the O-ring seal 132. To maximize thermal conductivity the cooling head is preferably made of aluminum or some other thermal conductor. Although not shown in Figure 2, a thermocouple may be disposed in a slot 222 to monitor the operating temperature at an upper end of the vaporizer 100. A dispersion/carrier gas conduit 135 is formed in the cooling head 104 and leads to a recess 137 formed in an upper portion of the top block 108. An injection line (not shown) connects the carrier gas B source (such as 61a, 61b, as shown in Figure 1) to the dispersion/carrier gas conduit 135 to provide a dispersion/carrier gas thereto. The cooling head 104 provides a centrally formed inlet bore 136 wherein the injection member 114 is disposed and secured by a threaded sleeve 138. The injection member 114 is concentrically received by a gas passageway 140 extending longitudinally through a neck 142 of the top block 108 and terminating near a lower end of the neck 142. The concentric gas passageway 140, disposed about the outer perimeter of the injection member 114, may be of any geometric shape and is adapted to deliver one or more dispersion gases to a tip, or nozzle 144, of the injection member 114. Preferably, the concentric gas passageway 140 and the injection member 114 are made of PTFE for low friction coefficient and prevention of clogging.

The concentric gas passageway 140 leads to a main vaporizing section 146 which is shown as a frustoconical surface having a diametrically narrower upper end and a diametrically enlarged lower end. The main vaporizing section 146 provides a large, preferably smooth, heated surface area onto which a fluid may be deposited. A blocker 148 aligned with the lower end of the main vaporizing section 146 provides an extended vaporizing surface. The blocker 148 is preferably made of aluminum, or some other thermal conductor, and comprises a plurality of high conductance channels 150. A commercially available filter 152 such as the one available from PALL is disposed below the blocker 148 and above a high conductance outlet 153. The filter 152 is seated on an annular shoulder 154 of the bottom block 110 and is secured from above by the top block 108 thereby allowing for ease of periodic replacement by unclamping the two blocks 108, 110. The filter 152 can be any number of commercially available filters such as the one available from PALL. This arrangement provides a large conductance for shorter resonance time in the vaporizer 100 and also facilitates inspection and cleaning of the vapor flow paths.

The blocks 108 and 110, preferably made of stainless steel, provide a relatively large thermal mass for retention and transmission of thermal energy generated by one or more heating elements 156 (shown here as cartridges) surrounding the blocks 108 and 110 thereby ensuring an optimal isothermal temperature on the vaporization surfaces, as well as downstream. The heaters 156 are slidably received in receptacles 158 and may be selectively removed for maintenance and servicing. The heating elements 156 preferably deliver a total heating power of between about 1000W and 3000W to the blocks 108, 110 and are controlled to maintain the main body 106 at the optimum isothermal temperature by a conventional PID controller (not shown). The controller is connected to a thermocouple (also not shown) positioned within at least one, and preferably both, of the blocks 108, 110 proximate to the heated vaporizing surfaces.

All the vaporizer components are uniquely designed to facilitate disassembly, maintenance, and replacement. Each component comprises an independent unit which may be individually serviced or replaced. As shown in Figure 2, the vaporizer 100 comprises six primary components, *i*.*e*., the input manifold 102, the cooling head 104, the top block 108, the bottom block 110, the heating elements 156, the filter 152, and the blocker 148. As described above, the top block 108 and cooling head 104 are selectively coupled with a KF clamp. The top block 108 is similarly coupled to the bottom block 110. Thus, the filer 152, which must be periodically exchanged, and the blocker 148, which may require periodic cleaning, may be removed by uncoupling the top block 108 from the bottom block 110. While the blocks 108, 110 are shown coupled by KF clamps, other coupling assemblies, such as VCR® fittings may be used to advantage.

In operation, the liquid precursor is delivered through the injection member 114 (preferably 2-20 mils inner diameter) to a point just above the main vaporizing section 146. In one embodiment, no carrier gas A is provided to the vaporizers. Alternatively, carrier gas A may be provided along with the precursor liquid to the vaporizers. The liquid is supplied at a sufficiently high flow rate which causes the liquid to exit the nozzle 144 and enter the main vaporizing section 146 as a jet of liquid with a high nozzle velocity. The flow meters or LFCs (shown in Figure 1) can be used to control the amount and flow rate of the liquid precursor and solvent mixture. The flow rate of the liquid is typically controlled by a flow controller such as the flow meter or LFC shown in Figure 1, in relation to the pressure provided by the push gas sources 90. As will be understood by a person skilled in the art, the flow velocity of the liquid precursors may be independently controlled by the flow of the carrier gas input to the vaporizer 100.

One or more dispersion/carrier gases (from carrier gas source B), such as argon or helium, are delivered through the dispersion/carrier gas conduit 135 and flowed concentrically about the injection member 114 to prevent liquid droplets from forming on the nozzle 144 and moving up the outer cylinder of the injection member 114. At the level of the nozzle 144, the dispersion/carrier gas picks up the liquid precursor mixture jetting out of the injection member 114 and carries the mixture down into the main vaporizing section 146 where the liquid precursor is vaporized. To allow for optimization of this initial "flash" vaporization, the spacing between the injection member nozzle 144 and the main vaporization section 146 is preferably adjustable. Adjustment of the flash vaporization to avoid a liquid droplet "dance on the frying pan" effect is obtained by adjusting the flow rate of the gas and liquid precursor mixture. The vaporized precursors are then channeled through the plurality of high conductance channels 150 formed in the blocker 148. The blocker 148 acts as a second stage vaporizer while simultaneously collecting unvaporized liquid and directing them into the filter 152. The filter 152 enables the entrapment of any liquid which is not vaporized. This prevents liquids from passing through the vaporizer 100 and into the chamber 12 (shown in Figure 1). The resultant deposition gas then passes through the vaporizer outlet 153 for delivery to the deposition chamber 12. The wide-mouthed outlet 153 is designed for large conductance so that precursor vapors are readily carried from the vaporizer 100 into the chamber 12.

All but a final short segment of the path of the liquid mixture is kept relatively cool (*e*.*g*., between about 170°C and about 220°C for PZT) by a thermal choke structure comprising the cooling channel 134 and physical separation of the main body 106 from the other upstream vaporizer components by the neck. The thermal choke isolates the upper portion of the vaporizer 100 from the heat generated by heating elements 156 and prevents heat loss and generation of cold spots without inducing significant detrimental cooling effects on the other system components. In particular, the design allows the main body 106 to be maintained at an optimal isothermal temperature (*e*.*g*., between about 170°C to about 220°C for PZT precursors).

Table 1 lists processing parameter ranges for forming a PZT film. Table 2 lists preferred processing parameter ranges for forming a PZT film. Table 3 list an example of processing parameter values.

**Table 1:**

| **Processing Parameter Ranges For Forming A PZT Film** | |
|---|---|
| Process Parameter | Range |
| Carrier Gas | Argon, Helium, Xenon, Neon, Krypton, or Nitrogen |
| Carrier Gas Flow in First Vaporizer for Pb Precursor | 100-1000 sccm |
| Carrier Gas Flow in Second Vaporizer for Zr/Ti Precursors | 100-1000 sccm |
| He Push Gas Pressure | 20-200 psi |
| Oxygen Flow | 100-3000 sccm |
| Pb(thd)₂ Concentration | 0.01-10M |
| Zr(OiPr)₂(thd)₂ Concentration | 0.01-10M |
| Ti(OiPr)₂(thd)₂ Concentration | 0.01-10M |
| Pb(thd)₂ Flow | 10-500 mg/min |
| Zr(OiPr)₂(thd)₂ Flow | 10-500 mg/min |
| Ti(OiPr)2(thd)2 Flow | 10-500 mg/min |
| Solvent | Organic straight-chain hydrocarbons; aromatic hydrocarbons; ethers, cyclic ethers, keytones or alcohols |
| Solvent Additives | Stabilizers/complexing agent such as EDTA, PMDETA |
| Pb Vaporizer/Manifold Temperature | 100-300°C |
| Zr/Ti Vaporizer/Manifold Temperature | 100-300°C |
| Jackets/Lid Temperature | 100-300°C |
| Feedthrough Temperature | 100-300°C |
| Substrate Support Member Temperature | 300-800°C |
| Substrate Temperature | 250-750°C |
| Showerhead/Substrate Support Member Spacing | 100-800 mils |
| Chamber Pressure | 0.1-100 Torr |
| Pb/(Zr+Ti) film composition ratio | 1.00-1.30 |
| Zr/(Zr+Ti) film composition ratio | 0.05-0.95 |

**Table 2:**

| **Preferred Processing Parameter Ranges For Forming A PZT Film** | |
|---|---|
| Process Parameter | Range |
| Carrier Gas | Argon or Helium |
| Carrier Gas Flow in First Vaporizer for Pb Precursor | 100-500 sccm |
| Carrier Gas Flow in Second Vaporizer for Zr/Ti Precursors | 100-500 sccm |
| Push Gas Pressure | 40-80 psi |
| Oxygen Flow | 300-700 sccm |
| Pb(thd)₂ Concentration | 0.1-0.5M |
| Zr(OiPr)₂(thd)₂ Concentration | 0.1-0.5M |
| Ti(OiPr)₂(thd)₂ Concentration | 0.1-0.5M |
| Pb(thd)₂ Flow | 50-200 mg/min |
| Zr(OiPr)₂(thd)₂ Flow | 50-200 mg/min |
| Ti(OiPr)₂(thd)₂ Flow | 50-200 mg/min |
| Solvent | Octane or tetrahydrofuran, with optionally added isopropyl alcohol and stabilizers such as PMDETA |
| Pb Vaporizer/Manifold Temperature | 180-220°C |
| Zr/Ti Vaporizer/Manifold Temperature | 180-220°C |
| Jackets/Lid Temperature | 180-220°C |
| Feedthrough Temperature | 180-220°C |
| Substrate Support Member Temperature | 550-700°C |
| Substrate Temperature | 500-600°C |
| Showerhead/Substrate Support Member Spacing | 250-500 mils |
| Chamber Pressure | 1-10 Torr |
| Pb/(Zr+Ti) film composition ratio | 1.00-1.20 |
| Zr/(Zr+Ti) film composition ratio | 0.2-0.7 |

**Table 3:**

| **Example of Processing Parameter Values for Forming a PZT Film:** | |
|---|---|
| Process Parameter | Value |
| He-B Flow in First Vaporizer for Pb Precursor | 250 sccm |
| He-B Flow in Second Vaporizer for Zr/Ti Precursors | 250 sccm |
| He Push gas Pressure | 60 psi |
| Oxygen Flow | 1000 sccm |
| 0.25M Pb(thd)₂ pmdeta in R Flow | 140 mgm |
| 0.060M Zr(OiPr)₂(thd)₂ + 0.040M Ti(OiPr)₂(thd)₂ in R Flow | 123 mgm |
| 0.020M Zr(OiPr)₂(thd)₂ + 0.080M Ti(OiPr)₂(thd)₂ in R Flow | 53 mgm |
| R solvent | 8:2:1 THF:IPA:PMDETA |
| Pb Vaporizer/Manifold Temperature | 180°C |
| Zr/Ti Vaporizer/Manifold Temperature | 210°C |
| Jackets/Lid Temperature | 180°C |
| Feedthrough Temperature | 190°C (provided by setpoint at 140°C) |
| Substrate Support Member Temperature | 690°C |
| Substrate Temperature | 565°C |
| Showerhead/Substrate Support Member Spacing | 350 mils |
| Chamber Pressure | 4 Torr |
| Deposition Time | 857 seconds / 1000Å film |
| Pb/(Zr+Ti) film composition ratio | 1.15 |
| Zr/(Zr+Ti) film composition ratio | 0.30 |

In operation, for forming a PZT film utilizing a CVD system as shown in Figure 1, the vaporized precursors are introduced into the CVD chamber along with oxygen to deposit PZT on a substrate disposed on the substrate support member. In one embodiment, the Pb precursor comprises 0.25M Pb(thd)2 in R flow, while the Zr/Ti precursor comprises 0.060M Zr(OiPr)₂(thd)₂ + 0.040M Ti(OiPr)₂(thd)₂ in R flow and 0.020M Zr(OiPr)₂(thd)₂ + 0.080M Ti(OiPr)₂(thd)₂ in R flow, wherein R represent a solvent comprising 8:2:1 THF:IPA:PMDETA, wherein tetrahydrofuran is THF, isopropyl alcohol is IPA, and pentamethyldiethylenetriamine is PMDETA. For the Zr/Ti precursors, the ratio of Zr/Ti preferably ranges from about 20/80 to about 60/40.

The invention provides an advantage over commonly practiced PZT deposition in that the invention promotes relatively higher disassociation of the PZT precursors, which leads to reduction in material costs. Another advantage provided by the invention is that the incorporation efficiencies are improved for all three elements (Pb, Zr and Ti). Associated with higher incorporation efficiencies, the overall deposition rate of the PZT film is also increased. Furthermore, the invention provides a common vaporization temperature window for all three precursors. Particularly, the lower vaporization temperature for the Zr precursor, which is similar to the Pb and Ti precursors, reduces or eliminates the need to have additional temperature controls to prevent condensation and decomposition of Pb and Ti precursors before entering chamber.

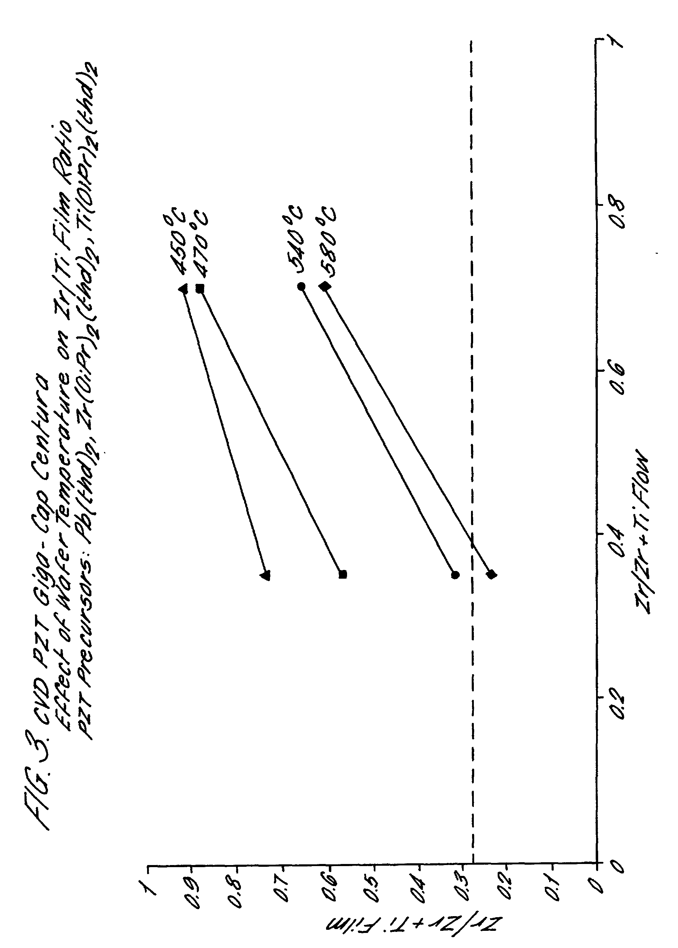

Another advantage provided by the invention is that the composition ratio of Zr to Ti incorporated into the deposited PZT film can be controlled by both the percentage of Zr in the combined Zr + Ti precursor and the substrate processing temperature. Figure 3 is a graphical representation illustrating the effects of substrate temperature on Zr/Ti ratio in a PZT film. The horizontal axis indicates the ratio of Zr to the combined Zr + Ti precursor. The vertical axis indicates the ratio of Zr content to the Zr + Ti deposited film. Figure 3shows the results for four substrate processing temperatures, 450°C, 470°C, 540°C and 580°C. As shown, the Zr content generally increases with decreasing substrate processing temperature. Thus, the invention provides for "tuning" the PZT film to a desired ZR content utilizing substrate temperature control. Also, the invention provides for high incorporation efficiency of Zr into the PZT film even at lower substrate processing temperatures and for formation of a PZT film having relatively higher Zr content at a lower substrate processing temperature without increasing the Zr content in the precursor.

Processing at lower temperatures provides a further advantage of reducing the thermal budget on the CVD system, which leads to reduction in costs associated with maintaining the CVD system within desired operating temperature ranges. Processing at lower temperatures may also increase throughput by reducing time required to heat up and or cool down the substrate for processing.

Another aspect of the invention provides film composition control which leads to improved film properties (e.g., electrical properties). Furthermore, process stability is enhanced. Thus, efficiency of the process and quality of the product are substantially improved.

Figure 4 is schematic diagram illustrating a CVD system 400 incorporating three vaporizers. The CVD system 400 include similar components as those described herein regarding Figure 1, except that individual precursor sources are vaporized in respective individual vaporizers. The CVD system 400 includes three vaporizers 30a, 30c and 30d, which are connected to precursor sources for Pb, Zr and Ti, respectively. This embodiment provides individual vaporizers to individual precursors, and thus, individual temperature control for each of the vaporization temperature of each precursor.

The Pb precursor is provided in an ampoule 46, which is connected to the vaporizer 30a through a liquid delivery line 48. A liquid flow controller (LFC) 50 is disposed on the liquid delivery line 48 to control the flow rate of precursor liquid to the vaporizer. A shutoff valve 52 is disposed on the liquid delivery line to prevent backflow or to terminate precursor flow when necessary. In addition to the Pb ampoule, a first solvent ampoule 54 is also fluidly connected to the vaporizer, in similar fashion as the Pb ampoule, with an LFC 56 and a shutoff valve 58. Similarly, the Zr precursor is provided in ampoule 66, which is connected to the vaporizer 30c through LFC 74 and shutoff valve 80. A second solvent ampoule 54 is also connected to the vaporizer 30c through LFC 56 and shutoff valve 58. The Ti precursor is provided in ampoule 67, which is connected to the vaporizer 30d through LFC 75 and shutoff valve 81. A third solvent ampoule 54 is connected to the vaporizer 30d through LFC 56 and shutoff valve 58. The vaporizers 30c and 30d include similar components (60, 61, 62, and 63) as described above for vaporizers 30a and 30b. One or more push gas sources 90 (two shown) are connected to the Pb, Zr, and Ti ampoules and the solvent ampoules to provide a push gas pressure (e.g., from about 20 psi to about 200 psi) to the precursor and solvent liquids in the ampoules. Operation of the CVD system 400 is similar to the above-described CVD system 10.

While the foregoing is directed to the preferred embodiments of the present invention, other and further embodiments of the invention may be devised without departing from the basic scope thereof. The scope of the invention is determined by the claims which follow.

## Claims

1. A method for forming a lead zirconate titanate (PZT) film on a substrate in a chemical vapor deposition chamber having one or more vaporizers fluidly connected thereto, the method comprising:
a) vaporizing lead bis (tetramethyl heptanedionate), zirconium bis (tetramethyl heptanedionate) bis (isopropoxy) and titanium bis (tetramethyl heptanedionate) bis (isopropoxy); and
b) introducing vaporized lead bis (tetramethyl heptanedionate), zirconium bis (tetramethyl heptanedionate) bis (isopropoxy) and titanium bis (tetramethyl heptanedionate) bis (isopropoxy) into the chamber.

2. The method of claim 1, wherein Pb(thd)₂, Zr(OiPr)₂(thd)₂ and Ti(OiPr)₂(thd)₂ are vaporized in one vaporizer.

3. The method of claim 1, wherein Pb(thd)₂, Zr(OiPr)₂(thd)₂ and Ti(OiPr)₂(thd)₂ are separately vaporized in three respective vaporizers.

4. The method of claim 1, wherein Pb(thd)₂ is vaporized in a first vaporizer and wherein Zr(OiPr)₂(thd)₂ and Ti(OiPr)₂(thd)₂ are vaporized in a second vaporizer.

5. The method of any one of claims 1 to 4, wherein Pb(thd)₂, Zr(OiPr)₂(thd)₂ and Ti(OiPr)₂(thd)₂ are vaporized along with a solvent.

6. The method of claim 5, wherein Pb(thd)₂, Zr(OiPr)₂(thd)₂ and Ti(OiPr)₂(thd)₂ are vaporized along with a solvent comprising:
one or more chemicals selected from organic straight-chain hydrocarbons, ethers, keytones, and alcohols; and
one or more additives selected from ethylenediamine and pentamethyldiethylenetriamine.

7. The method of claim 6, wherein Pb(thd)₂, Zr(OiPr)₂(thd)₂ and Ti(OiPr)₂(thd)₂ are vaporized along with a solvent comprising:
i) tetrahydrofuran (THF);
ii) isopropyl alcohol (IPA) ; and
iii) pentamethyldiethylenetriamine (PMDETA).

8. The method of claim 7, wherein a ratio of THF to IPA to PMDETA is about 8:2:1.

9. The method of any one of claims 1 to 8, wherein Zr(OiPr)₂(thd)₂ and Ti(OiPr)₂(thd)₂ comprise:
i) about 0.06M Zr(OiPr)₂(thd)₂ and about 0.04M Ti(OiPr)₂(thd)₂; and
ii) about 0.02M Zr(OiPr)₂(thd)₂ and about 0.08M Ti(OiPr)₂(thd)₂.

10. The method of any one of claims 1 to 9, wherein Pb(thd)₂, Zr(OiPr)₂(thd)₂ and Ti(OiPr)₂(thd)₂ have molar concentrations between about 0.01M and about 10M, preferably between about 0.1M and about 0.5M.

11. The method of any one of claims 1 to 10, further comprising:
c) introducing a carrier gas into the one or more vaporizers to flow vaporized Pb(thd)₂, Zr(OiPr)₂(thd)₂ and Ti(OiPr)₂(thd)₂ into the CVD chamber.

12. The method of any one of claims 1 to 11, further comprising:
c) introducing oxygen into the CVD chamber while vaporized Pb(thd)₂, Zr(OiPr)₂(thd)₂ and Ti(OiPr)₂(thd)₂ are introduced into the CVD chamber.

13. The method of any one of claims 1 to 12, wherein Pb(thd)₂, Zr(OiPr)₂(thd)₂ and Ti(OiPr)₂(thd)₂ are vaporized in one or more vaporizers at vaporizing temperatures between about 100°C and about 300°C, preferably between about 180°C and about 220°C.

14. The method of any one of claims 1 to 13, wherein a temperature of the substrate is maintained at between about 250°C and about 750°C during deposition, preferably between about 500°C and about 600°C.

15. The method of any one of claims 1 to 14, wherein a chamber pressure is maintained at between about 0.1 torr and about 100 torr, preferably between about 1 torr and about 10 torr.

16. The method of any one of claims 1 to 15, wherein a distance between a gas distributor and a substrate support member in the chamber is between about 100 mils and about 800 mils.

17. An apparatus for forming a lead zirconate titanate (PZT) film on a substrate, the apparatus comprising:
a) a CVD chamber having a gas distribution system and a substrate support;
b) one or more vaporizers fluidly connected to the gas distribution system of the CVD chamber, each vaporizer including a temperature controller;
c) an oxygen gas source fluidly connected to the gas distribution system of the CVD chamber; and
d) one or more precursor sources fluidly connected to the one or more vaporizers, the one or more precursor sources comprising Pb(thd)₂, Zr(OiPr)₂(thd)₂ and Ti(OiPr)₂(thd)₂, wherein Pb(thd)₂, Zr(OiPr)₂(thd)₂ and Ti(OiPr)₂(thd)₂ are vaporized in the one or more vaporizers at vaporizing temperatures between about 100°C and about 300°C.

18. The apparatus of claim 17, wherein each temperature controller controls vaporizing temperatures between about 180°C and about 220°C.

19. The apparatus of claim 17 or claim 18, wherein each of the one or more vaporizers includes a gas inlet for a carrier gas.

20. The apparatus of any one of claims 17 to 19, wherein the Pb(thd)₂ precursor source is fluidly connected through a first mass flow controller to a first vaporizer and the Zr(OiPr)₂(thd)₂ and Ti(OiPr)₂(thd)₂ precursor sources are fluidly connected through a second mass flow controller to a second vaporizer.

21. The apparatus of any one of claims 17 to 20, further comprising:
e) one or more solvent sources fluidly connected to the one or more vaporizers.

22. A vaporizable precursor for forming a PZT film on a substrate in a chamber, said precursor comprising:
a) Pb(thd)₂;
b) Zr(OiPr)₂(thd)₂;
c) Ti(OiPr)₂(thd)₂; and
d) a solvent.

23. The precursor of claim 22, wherein Pb(thd)₂, Zr(OiPr)₂(thd)₂ and Ti(OiPr)₂(thd)₂ have molar concentrations between about 0.01M and about 10M, preferably between about 0.1M and about 0.5M.

24. The precursor of claim 22 or claim 23, wherein Zr(OiPr)₂(thd)₂ and Ti(OiPr)₂(thd)₂ comprise:
i) about 0.06M Zr(OiPr)₂(thd)₂ and about 0.04M Ti(OiPr)₂(thd)₂; and
ii) about 0.02M Zr(OiPr)₂(thd)₂ and about 0.08M Ti(OiPr)₂(thd)₂.

25. The precursor of any one of claims 22 to 24, wherein the solvent comprises:
i) THF;
ii) IPA; and
iii) PMDETA.

26. The precursor of claim 25, wherein a ratio of THF to IPA to PMDETA is about 8:2:1.
